# EUROPÄISCHE PATENTSCHRIFT

(11) **EP 2 383 763 B1**
(45) Veröffentlichungstag und Bekanntmachung des Hinweises auf die Patenterteilung: **21.07.2021**
(21) Anmeldenummer: 11002953.5
(22) Anmeldetag: 08.04.2011
(51) Int. Cl.: H01H 47/00, G01R 15/20

(54) **Relais, insbesondere für den Hochstrombereich**
Relay, in particular for high voltage use
Relais, notamment pour le domaine de haute intensité

(30) Priorität: 29.04.2010 DE 102010018739
(43) Veröffentlichungstag der Anmeldung: 02.11.2011
(73) Patentinhaber: TE Connectivity KISSLING Products GmbH, 72218 Wildberg (DE)
(72) Erfinder: Kalmbach, Simon, 72213 Altensteig (DE); Hengstler, Roland, 72108 Rottenburg (DE); Kern, Werner, 75387 Neubulach (DE); Grindemann, Uwe, 75387 Neubulach (DE)
(74) Vertreter: Grünecker Patent- und Rechtsanwälte PartG mbB

(56) Entgegenhaltungen:
- EP-A2- 1 037 240
- WO-A1-90/11529
- WO-A1-99/36928
- US-B1- 6 252 389

## Beschreibung

Die Erfindung bezieht sich auf ein Relais, insbesondere für den Hochstrombereich, mit den Merkmalen des Oberbegriffs des Anspruchs 1.

Ein solches Relais ist aus der US 6,252,389 B1 bekannt.

Relais weisen insbesondere im Hochstrombereich oftmals eine Strom- und Messeinrichtung auf, um den über die Hauptkontaktanschlüsse fließenden Strom erfassen zu können. Hierzu werden in der Regel Hall-Sensoren eingesetzt, um die fließenden Ströme nicht direkt messen zu müssen, sondern indirekt, d. h. galvanisch getrennt über das durch den Strom induzierte Magnetfeld erfassen zu können. Das magnetische Feld wird allerdings nicht nur am Hall-Sensor, sondern am ganzen Relais induziert. Durch die Remanenzeffekte im Relais kann diese Magnetisierung zu Fehlern bei der Strommessung führen. Wird die Stromrichtung in einem solchen magnetisierten Relais umgedreht, so wird das vom Stromfluss erzeugte Magnetfeld um das Magnetfeld des vormagnetisierten Relais abgeschwächt. Dies wird vom Hall-Sensor als ein zu niedriger Strom interpretiert. Die Messgenauigkeit des oder der Hall-Sensoren wird dadurch erheblich beeinträchtigt.

Die EP 1 037 240 A2 beschreibt ein Relais mit Hall-Sensoren, die durch eine lamellierte Abschirmung vom Einfluss magnetischer Felder geschützt werden.

Aus der WO 99/36928 A1 ist eine Stromabschalteinrichtung für die drei Phasen eines Drehstromanschlusses mit Hall-Sensoren bekannt, die Gleichrichterschaltungen für die drei Phasenströme aufweist.

Der Erfindung liegt demgegenüber die Aufgabe zugrunde, eine Strommesseinrichtung für ein Relais bereitzustellen, mit der ein über die Hauptkontaktanschlüsse des Relais fließender Strom genau gemessen werden kann.

Diese Aufgabe wird erfindungsgemäß durch ein Relais mit den Merkmalen des Anspruchs 1 gelöst.

Durch die Einrichtung zur Ausrichtung des magnetischen Flusses wird der magnetische Fluss auf den oder die Hall-Sensoren konzentriert. Somit wird der Einfluss anderer magnetischer Bereiche des Relais vermindert, wodurch die Messgenauigkeit der Strommesseinrichtung erheblich erhöht werden kann. Um einen größeren räumlichen Bereich zur Strommessung abdecken zu können, können mehrere Hall-Sensoren verwendet werden.

Die Einrichtung zur Ausrichtung des magnetischen Flusses weist dabei mindestens einen die Hauptkontaktanschlüsse umfließenden und mit einem Freiraum für den oder die Hall-Sensoren versehenen ferromagnetischen Körper auf. In den ferromagnetischen Körper wird durch den durch die Hauptkontaktanschlüsse fließenden Strom ein starkes Magnetfeld induziert. In einem Freiraum (Luftspalt) des ferromagnetischen Körpers, in dem der oder die Hall-Sensoren angeordnet sind, ist das induzierte Magnetfeld besonders hoch, sodass die Strommesseinrichtung eine sehr hohe Genauigkeit aufweisen kann.

Erfindungsgemäß ist die Strommesseinrichtung des Relais derart ausgebildet, dass der ferromagnetische Körper ringförmig beide Hauptkontakte umgreift und zwischen den Hauptkontakten in einem inneren Freiraum mindestens ein Hall-Sensor angeordnet ist. Hierbei sind die beiden Hauptkontakte parallel und nebeneinander angeordnet. Im Freiraum des ferromagnetischen Körpers können ein oder mehrere Hall-Sensor/en angeordnet sein, um in das Relais ein- und ausfließende Ströme zu messen.

Der oder die ferromagnetischen Körper sind aus einem Stapel von ferromagnetischen Blechen gebildet. Durch die Aufteilung des ferromagnetischen Körpers in ein Bündel einzelner Bleche kann die Remanenz des ferromagnetischen Körpers deutlich reduziert werden. Als Werkstoff für den Blechstapel kann beispielsweise ein veredeltes Elektroblech eingesetzt werden. Die Verwendung eines Stapels ferromagnetischer Bleche sorgt somit nicht nur für eine Bündelung des magnetischen Flusses, sondern auch für eine Reduktion der Remanenz. Die Messgenauigkeit der Strommesseinrichtung des Relais kann hierdurch weiter erhöht werden.

Weiter können mit der Strommesseinrichtung über die Hauptkontakte fließende Ströme in beide Stromrichtungen gemessen werden. Hierdurch sind die Einsatzmöglichkeiten des Relais sehr groß.

Weiter weist die Strommesseinrichtung einen Mikrocontroller auf, mit dem von dem oder den Hall-Sensor/en gemessene Ströme erfassbar und weiterverarbeitbar sind. Durch den Einsatz des Mikrocontrollers kann ein automatisches Abschalten des Relais bei Überstrom erreicht werden. Über den Mikrocontroller kann so eine Sicherheitsabschaltung des Relais auslösbar sein. Hierzu können beispielsweise frei programmierbare Überstromabschaltschwellen im Mikrocontroller hinterlegt werden. Darüber hinaus kann durch den Mikrocontroller eine Sicherungskennlinie einer herkömmlichen Einwegsicherung nachgebildet werden.

Weiterhin bietet der Mikrocontroller die Möglichkeit, eine Nachbildung einer herkömmlichen Schmelzsicherungskennlinie als Auslösecharakteristik zu verwenden. Der Mikrocontroller wertet dann das von der Strommesseinrichtung gemessene Signal aus und kann durch einen Vergleich mit der hinterlegten Schmelzsicherungskennlinie die Beschädigung eines Bauteils im Stromkreis erkennen und im Relais den Stromkreis unterbrechen.

Ein weiterer Vorteil des Mikrocontrollers ist die Möglichkeit des Ein- und Ausschaltens des Relais über einen Steuereingang. Durch den Mikrocontroller können weiterhin auch eine Unterspannungsabschaltschwelle sowie eine Übertemperaturabschaltung und die Ausgabe eines Statussignals zur Anzeige des Betriebszustands realisiert werden. Am Mikrocontroller kann auch eine minimale Versorgungsspannung vorgegeben werden. Der Mikrocontroller kann dann so programmiert werden, dass das Relais bei einer Unterschreitung dieser Versorgungsspannung nicht eingeschaltet werden kann, um beispielsweise eine schwache Batterie durch einen über das Relais zuschaltbaren elektrischen Verbraucher nicht weiter zu belasten. Schließlich können durch den Mikrocontroller kurzzeitige Stromspitzen von der Beeinflussung des Messergebnisses ausgeschlossen werden. So lassen sich beispielsweise Fehlinterpretationen der Messergebnisse infolge von Einschaltstromspitzen dadurch vermeiden, dass der Mikrocontroller die Strommesseinrichtung vom Einschaltzeitpunkt an für eine variable Zeit ausblendet. Auch Betriebsstromspitzen können vom Mikrocontroller erkannt und "ausgeblendet" werden.

Vorzugsweise können die über den oder die Hall-Sensor/en gemessenen Ströme über den Mikrocontroller analog/digital wandelbar sein. Der Mikrocontroller bietet hierdurch weitere Verarbeitungsmöglichkeiten des gemessenen Stroms. Der gemessene Strom kann beispielsweise digital gewandelt und weiterverarbeitet werden. Die Messgenauigkeit der Strommesseinrichtung bleibt dabei erhalten.

Das erfindungsgemäße Relais kann überall dort eingesetzt werden, wo das Relais als Sicherung dient oder Ströme gemessen und ausgegeben werden sollen.

Nachfolgend wird ein Ausführungsbeispiel der Erfindung in der Zeichnung näher beschrieben.

Es zeigen:
- Fig. 1: eine perspektivische, teilweise geschnittene Darstellung eines bevorzugten Ausführungsbeispiels der Erfindung;
- Fig. 2: eine perspektivische Darstellung einer Anschlusseinheit aus Fig. 1;
- Fig. 3: eine perspektivische, teilweise geschnittene Darstellung eins nicht von der Erfindung umfassten Relais.

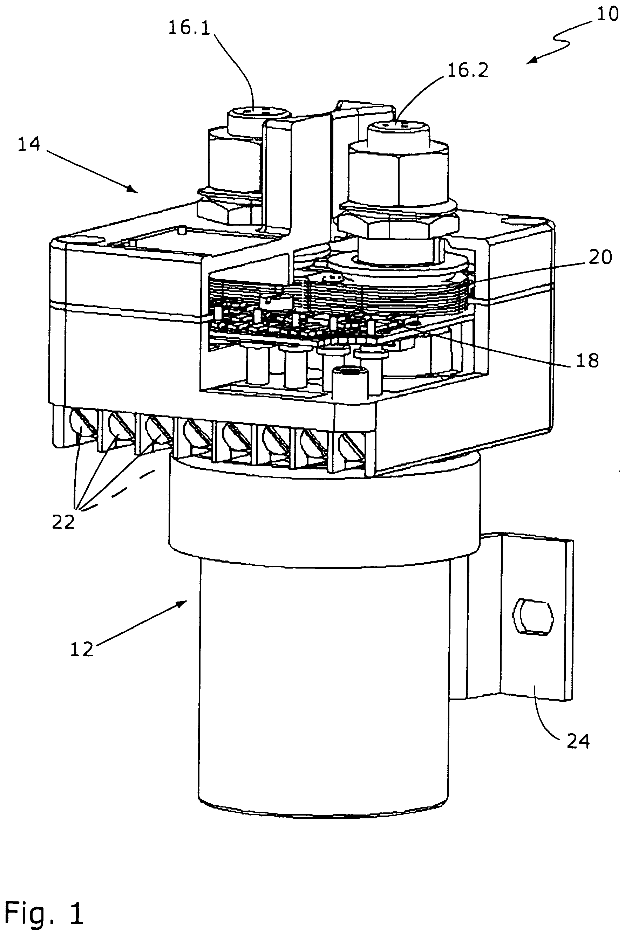

Fig. 1 zeigt ein Ausführungsbeispiel eines erfindungsgemäßen Relais 10, das einen Grundkörper 12 und eine Anschlusseinheit 14 umfasst. Die Anschlusseinheit 14 weist zwei Hauptkontaktanschlüsse 16.1, 16.2 auf.

Die Hauptkontaktanschlüsse 16.1, 16.2 können durch eine Hauptkontaktbrücke (nicht gezeigt) durch einen Schaltvorgang im Relais elektrisch verbunden werden. Neben den

Hauptkontaktanschlüssen 16.1, 16.2 weist die Anschlusseinheit 14 eine Strommesseinrichtung auf, die einen Mikrocontroller 18 und eine Einrichtung 20 zur Ausrichtung des magnetischen Flusses umfasst. Weiterhin weist die Anschlusseinheit 14 Steuerkontakte 22 zur Steuerung des Relais 10 auf. Das Relais 10 kann über einen Seitenflansch 24 beispielsweise in einem Fahrzeug befestigt werden.

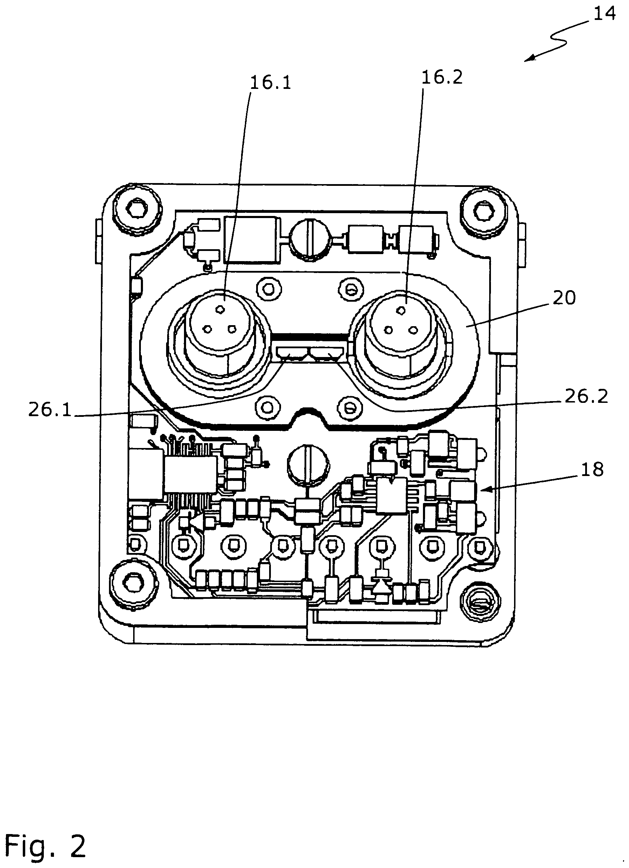

In Fig. 2 ist die Anschlusseinheit 14 des Relais 10 in einer perspektivischen Draufsicht dargestellt. In diesem in Fig. 2 dargestellten ersten Ausführungsbeispiel der Erfindung ist die Einrichtung 20 zur Ausrichtung des magnetischen Flusses als ein ferromagnetischer Körper ausgebildet, der die beiden Hauptkontaktanschlüsse 16.1, 16.2 ringförmig umgreift und einen inneren Freiraum aufweist, in dem zwei Hall-Sensoren 26.1, 26.2 angeordnet sind. Wird das Relais 10 eingeschaltet, fließt je nach Stromrichtung ein Strom vom Hauptkontaktanschluss 16.1 zum Hauptkontaktanschluss 16.2 oder umgekehrt. Sowohl der in das Relais 10 hineinfließende Strom als auch der aus dem Relais 10 herausfließende Strom induziert ein Magnetfeld, das von der Einrichtung 20 zur Ausrichtung des magnetischen Flusses auf die Hall-Sensoren 26.1, 26.2 gebündelt und verstärkt wird. Der Hall-Sensor 26.1 kann dabei zur Messung niedrigerer Ströme und der Hall-Sensor 26.2 zur Messung höherer Ströme ausgelegt sein. Genauer gesagt, kann an den Hall-Sensoren 26.1, 26.2 jeweils eine Spannung abgegriffen werden, die einem durch das Relais 10 fließenden Strom entspricht. Die an den Hall-Sensoren 26.1, 26.2 abgegriffene Spannung wird hierzu vom Mikrocontroller 18 ausgewertet.

Überschreitet der durch das Relais 10 fließende Strom einen bestimmten Schwellwert, so kann der Mikrocontroller 18 durch ein Ausschalten des Relais 10 den über die Hauptkontaktanschlüsse 16.1, 16.2 geschlossenen Stromkreis unterbrechen. Dabei können - je nach Programmierung des Mikrocontrollers 18 - kurzzeitige Stromspitzen ignoriert werden. Darüber hinaus kann der Mikrocontroller 18 die von den Hall-Sensoren 26.1, 26.2 gemessene Stromstärke analog oder digital ausgeben.

Aus einer Zusammenschau der Fig. 1 und 2 wird deutlich, dass die Einrichtung 20 zur Ausrichtung des magnetischen Flusses aus einem Stapel vorzugsweise ferromagnetischer Bleche besteht. Die ferromagnetischen Eigenschaften der Einrichtung 20 zur Ausrichtung des magnetischen Flusses ermöglichen eine Konzentration des magnetischen Flusses an den Hall-Sensoren 26.1, 26.2. Gleichzeitig wird durch die Aufteilung der Einrichtung 20 zur Ausrichtung des magnetischen Flusses in einzelne Blechlagen eine niedrige Remanenz erreicht. Eine Änderung der Stromstärke oder Stromrichtung des durch die Hauptkontaktanschlüsse 16.1, 16.2 fließenden Stroms kann somit schnell und genau durch die Hall-Sensoren 26.1, 26.2 erfasst werden.

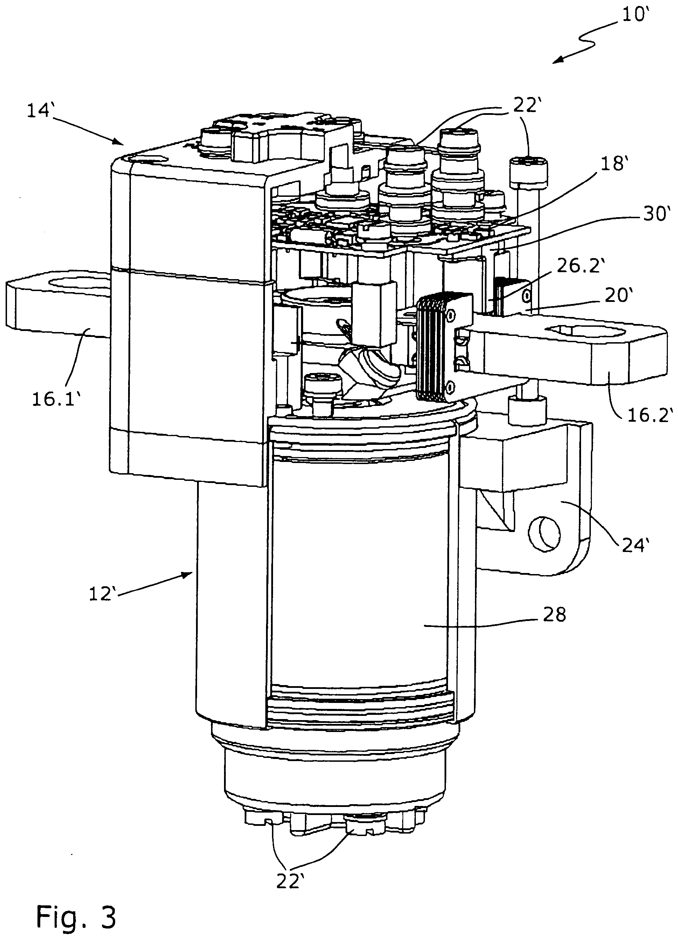

Fig. 3 zeigt ein Relais 10', das nicht von der Erfindung umfasst ist. Das Relais 10' umfasst einen Grundkörper 12' und eine Anschlusseinheit 14'. In der teilweise geschnittenen Ansicht des Grundkörpers 12' ist eine Spule 28 erkennbar, die beispielsweise einteilig oder als Anzugs- und Abwurfspule ausgebildet sein kann. Die Anschlusseinheit 14' des erfindungsgemäßen Relais 10' weist gemäß dem in Fig. 3 dargestellten Ausführungsbeispiel zwei Hauptkontaktanschlüsse 16.1', 16.2' auf, die seitlich vom Relais 10' abstehen.

Durch den im Vergleich zum Relais aus Fig. 1 größeren Abstand der Hauptkontaktanschlüsse 16.1', 16.2' kann das Relais 10' zum Schalten noch höherer Ströme verwendet werden. Zur Steuerung des Relais 10' sind an dessen Ober- und Unterseite Steuerkontakte 22' angeordnet. Um die beiden Hauptkontaktanschlüsse 16.1', 16.2' befinden sich jeweils Einrichtungen 20' zur Ausrichtung des magnetischen Flusses.

Wie beim Ausführungsbeispiel aus den Fig. 1 und 2 bestehen die Einrichtungen 20' zur Ausrichtung des magnetischen Flusses aus Stapeln ferromagnetischer Bleche. Die Einrichtungen 20' zur Ausrichtung des magnetischen Flusses weisen an ihrer Oberseite Öffnungen auf, in denen Hall-Sensoren 26.1' (in Fig. 3 nicht gezeigt) und 26.2' angeordnet sind. Die Hall-Sensoren 26.1', 26.2' werden von einem T-förmigen Träger 30' in der Öffnung der Einrichtung 20' zur Ausrichtung des magnetischen Flusses gehalten. Hierdurch kann ebenso wie im oben beschriebenen Ausführungsbeispiel der durch die Hauptkontaktanschlüsse 16.1', 16.2' fließende Strom galvanisch getrennt erfasst werden.

Ein Mikrocontroller 18' kann die gemessene Stromstärke analog oder digital ausgeben. Gleichzeitig kann der Mikrocontroller 18' bei zu hohen oder zu niedrigen Strömen die Verbindung zwischen den beiden Hauptkontaktanschlüssen 16.1', 16.2' des Relais 10' unterbrechen.

## Patentansprüche

1. Relais (10), insbesondere für den Hochstrombereich, mit mindestens einer Spule (28) und einem beweglichen Anker, der durch den in der mindestens einen Spule (28) erzeugbaren magnetischen Fluss einen Stromfluss über zwei Hauptkontaktanschlüsse (16.1, 16.2; 16.1', 16.2') zulässt oder unterbricht, und mit einer Strommesseinrichtung zur Messung mindestens des über die Hauptkontaktanschlüsse (16.1, 16.2; 16.1', 16.2') fließenden Stroms mittels mindestens eines Hall-Sensors (26.1, 26.2; 26.2'), wobei um die Hauptkontaktanschlüsse (16.1, 16.2; 16.1', 16.2') eine Einrichtung (20, 20') zur Ausrichtung des magnetischen Flusses auf den oder die Hall-Sensor/en (26.1, 26.2; 26.2') vorgesehen ist, **dadurch gekennzeichnet, dass** die Einrichtung (20, 20') zur Ausrichtung des magnetischen Flusses einen die beiden Hauptkontaktanschlüsse (16.1, 16.2; 16.1', 16.2') ringförmig umschließenden ferromagnetischen Körper aufweist, wobei der ferromagnetische Körper (20, 20') aus einem Stapel von ferromagnetischen Blechen gebildet ist und zwischen den Hauptkontaktanschlüssen (16.1, 16.2) in einem inneren Freiraum mindestens ein Hall-Sensor (26.1, 26.2) angeordnet ist und wobei die Strommesseinrichtung einen Mikrocontroller (18, 18') aufweist, mit dem von dem oder den Hall-Sensor/en (26.1, 26.2; 26.2') gemessene Ströme in beiden Stromrichtungen erfassbar und weiterverarbeitbar sind.

2. Relais nach Anspruch 1, **dadurch gekennzeichnet, dass** die Ströme über den Mikrocontroller (18, 18') analog/digital wandelbar sind.

3. Relais nach einem der Ansprüche 1 - 2, **dadurch gekennzeichnet, dass** über den Mikrocontroller (18, 18') eine Sicherheitsabschaltung des Relais (10, 10') auslösbar ist.

## Claims

1. A relay (10), in particular for the high-current range, comprising at least one coil (28) and a movable armature which allows or interrupts current flow via two main contact terminals (16.1, 16.2; 16.1', 16.2') by means of the magnetic flux which can be generated in the at least one coil (28), and including a current-measuring device for measuring at least the current flowing via the main contact terminals (16.1, 16.2; 16.1', 16.2') by means of at least one Hall sensor (26.1, 26.2; 26.2'), wherein a device (20, 20') for aligning the magnetic flux with the one or more Hall sensor/s (26.1, 16.2; 16.1', 16.2') is provided around the main contact terminals (16.1, 16.2; 16.1', 16.2'), **characterized in that** the device (20, 20') for aligning the magnetic flux includes a ferromagnetic body which surrounds the two main contact terminals (16.1, 16.2; 16.1', 16.2') in annular form, the ferromagnetic body (20, 20') being formed from a stack of ferromagnetic sheets and at least one Hall sensor (26.1, 26.2) is arranged between the main contact terminals (16.1, 16.2) in a free internal space, and the current measuring device has a microcontroller (18, 18') with which currents measured by the one or more Hall sensor/s (26.1, 26.2; 26.2') in both current flow directions can be detected and subjected further processing.

2. The relay according to claim 1, **characterized in that** the currents can be subjected analog/digital conversion by the microcontroller (18, 18').

3. The relay according to any one of claims 1 - 2, **characterized in that** an emergency shutdown of the relay (10, 10') can be triggered via the microcontroller (18, 18').

## Revendications

1. Relais (10), en particulier pour un domaine forte intensité, avec au moins une bobine (28) et un induit mobile qui laisse passer ou interrompt un courant passant par deux connexions de contact principal (16.1, 16.2 ; 16.1', 16.2') grâce au flux magnétique produit par ladite au moins une bobine (28), et avec un dispositif de mesure de courant pour la mesure au moins du courant passant par les connexions de contact principal (16.1, 16.2 ; 16.1', 16.2') au moyen d'au moins un capteur à effet Hall (26.1, 26.2 ; 26.2'), dans lequel un dispositif (20, 20') d'orientation du flux magnétique du ou des capteurs à effet Hall (26.1, 26.2 ; 26.2') est pourvu autour des connexions de contact principal (16.1, 16.2 ; 16.1', 16.2'), **caractérisé en ce que** le dispositif d'orientation du flux magnétique (20, 20') comporte un corps ferromagnétique annulaire entourant les deux connexions de contact principal (16.1, 16.2 ; 16.1', 16.2') pour l'orientation du flux magnétique, dans lequel le corps ferromagnétique (20, 20') est constitué par une pile de tôles ferromagnétiques et au moins un capteur à effet Hall (26.1, 26.2) est agencé entre les connexions de contact principal (16.1, 16.2) dans un espace libre interne, et dans lequel le dispositif de mesure de courant comporte un microcontrôleur (18, 18') grâce auquel les courants mesurés par le ou les capteurs à effet Hall (26.1, 26.2 ; 26.2') peuvent être captés dans les deux sens de courant et traités.

2. Relais selon la revendication 1, **caractérisé en ce que** les courants peuvent être convertis analogiquement ou numériquement par le microcontrôleur (18, 18').

3. Relais selon l'une des revendications 1 et 2, **caractérisé en ce qu'**une coupure de sécurité du relais (10, 10') peut être déclenchée par le microcontrôleur (18, 18').
